## Europäisches Patentamt
## European Patent Office
## Office européen des brevets

(19)

(11) Publication number: **0 020 135**
A1

(12) # EUROPEAN PATENT APPLICATION

(21) Application number: 80301762.3

(22) Date of filing: 28.05.80

(51) Int. Cl.³: **H 01 L 21/20, H 01 L 29/04, H 01 L 27/06**

(30) Priority: **29.05.79 US 433389**

(43) Date of publication of application: **10.12.80 Bulletin 80/25**

(84) Designated Contracting States: **DE FR GB NL**

(71) Applicant: **MASSACHUSETTS INSTITUTE OF TECHNOLOGY, 77 Massachusetts Avenue, Cambridge Massachusetts 02139 (US)**

(72) Inventor: **Smith, Henri I., 437, Peakham Road, Sudbury Massachusetts 01776 (US)**
Inventor: **Flanders, Dale C., 15, Preston Road, Lexington Massachusetts 02173 (US)**
Inventor: **Geis, Michael W., 132, Parker Street Apt. 51, Acton Massachusetts 01720 (US)**

(74) Representative: **Brunner, Michael John et al, Gill Jennings & Every 53 to 64, Chancery Lane, London WC2A 1HN (GB)**

(54) **Three-dimensional integration by graphoepitaxy.**

(57) The invention relates to a method of making multi-level semi conductor devices which include a first level of devices (12) in the surface of a wafer (11) of semi conductor material and a first film (13) of material deposited on the wafer surface. To produce a further level of devices one or more artificial defects (14) are fabricated in the surface of the first film (13) and a second film (15) of semi conductor material is deposited on the artificial defects so that the crystallographic orientation is influenced by the geometric arrangement of the defect or defects. A second level of semi conductor devices (16) can then be fabricated above the first level in the second film (15).

3D INTEGRATION BY GRAPHOEPITAXY

- 1 -    GJE 5180/065

MASSACHUSETTS INSTITUTE OF TECHNOLOGY.

THREE-DIMENSIONAL INTEGRATION BY GRAPHOEPITAXY.

This invention relates to a method of making multilevel semiconductor devices by a graphoepitaxial method.

Much modern technology makes use of thin solid films on the surfaces of solid substrates. Epitaxial and preferred orientation films are particularly important, notably in microelectronic devices, thin film optical devices and solar cells. Thus, improved methods of preparing epitaxial and preferred orientation films are of great importance. At present. microelectronic devices, thin film optical devices and solar cells are confined to substantially planar, single-level, configurations. The present invention represents an improvement in our previous proposals relating to graphoepitaxy in order to provide multilevel films that are epitaxial or of preferred orientation, thereby enabling fabrication of microelectronic and thin film optical devices and solar cells with the benefits of multiple level configuration.

We have previously proposed creating a plurality of artificial defects at predetermined locations at the surface of a solid substrate, to determine, control or influence, by means of the geometric arrangement of the adjacent defects, the crystallographic orientation of a film deposited on the surface. The artificial defects are either (1) artificial point defects or (2) artificial surface relief structure. This method was named "graphoepitaxy" (see "Crystallographic Orientation of Silicon on an Amorphous Substrate Using an Artificial Surface Relief Grating and Laser Crystallization", by M. W. Geis, D.C.Flanders and H.I.Smith, published in Applied Physics Letters July 1, 1979), and is derived from the Greek ("grapho" meaning to write or incise) and was chosen to convey the principle of using an artificially created surface pattern to induce epitaxy. In a copending application (Attorney's reference GJE 5180/064) entitled "IMPROVING GRAPHOEPITAXY" we teach determining, controlling, or influencing the crystallographic orientation of a film by the geometric arrangement of a single defect. The present invention uses graphoepitaxy to provide films suitable for multilevel devices.

According to the present invention a method of making multilevel semiconductor devices which includes the steps of forming a first level of devices in the surface of a wafer of semiconductor material, and depositing a first film of material on the wafer surface, is characterized in that one or more artificial defects are fabricated in the surface of the first film, and thereafter a second film of semiconductor material is deposited on the artificial defect or defects so that its crystallographic orientation is influenced by the defect or defects, and a second level of semiconductor devices are fabricated, above the first level, in the second film.

One or more artificial defects may be created at the surface of an amorphous or polycrystalline film which is located on top of a first level of material that contains devices (such as microelectronic devices, thin film optical devices, or solar cells) or is suitable for containing such devices. The artificial defects are either artificial point defects or artificial surface relief structure, and are employed to determine, control or influence the crystallographic orientation of a film deposited on top of the amorphous or polycrystalline film thus forming a second level of material suitable for devices.

The invention also includes adding additional levels of material suitable for devices above the second level using the same basic sequence of steps, and the method may include depositing a third film of material on the surface of the second film, fabricating a second set of one or more artificial defects in the surface of the third film, depositing a fourth film of semiconductor material on the second set of defects so that its crystallographic orientation is influenced by the second set and fabricating a further level of semiconductor devices, above the second level, in the fourth film. An amorphous or polycrystalline film can be deposited over the underlying level, artificial defects (either point defects or surface relief structure) formed in this film, and a level of material deposited over the artificial defects such that the crystallographic orientation of the material is determined, controlled or influenced by the artificial defects.

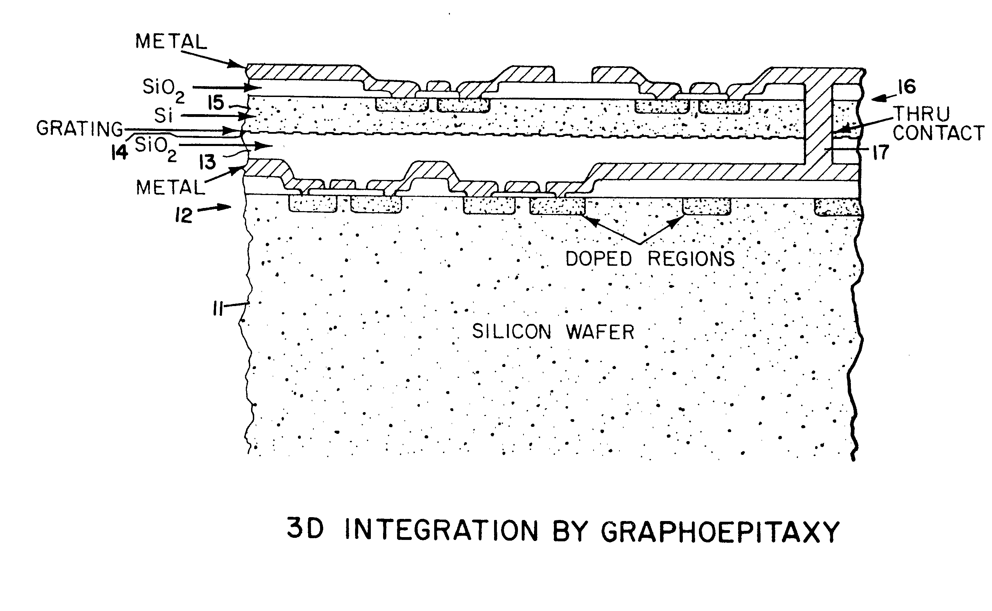

One example of a device constructed in accordance with the invention will now be described with reference to the accompanying drawing which is a cross-sectional diagram of a two-level semi-conductor device.

Referring to the drawing, there is shown a cross-sectional diagram of a two-level device in which the first level is a conventional silicon wafer 11 in whose surface microelectronic devices 12 are fabricated. The drawing depicts conventional field-effect transistors. On top of this first level a film of $SiO_2$ 13 is deposited and at the top surface of this film a relief structure 14 is fabricated using, for example, the methods that we have previously disclosed or as disclosed in the above-mentioned copending application. On top of this relief structure, a second level of silicon 15 is deposited in such a way that its crystallographic orientation is determined, controlled or influenced by the geometric arrangement of the artificial surface relief structure 14. The drawing depicts an epitaxial film of silicon 15 as the second level. Conventional field effect transistors 16 are fabricated in this second silicon level, and interconnected both within the second level and, by means of a thru-contact 17, into the first level.

The techniques just described may be repeated to establish a number of levels, and different types of components may be fabricated in the different levels. For example, it may be advantageous to have one or more lower levels with active devices interconnected to form electronic circuits and one or more upper levels may comprise solar cells that may provide the electrical power for the circuitry below. The ability to stack circuits in different levels and stagger them in planes parallel to the surface of the wafer facilitates short connections between cascaded active and/or passive devices that afford the circuit designer numerous advantages in connection with performance and design.

CLAIMS.

1.     A method of making multilevel semiconductor devices which includes the steps of forming a first level of devices (12) in the surface of a wafer (11) of semiconductor material, and depositing a first film (13) of material on the wafer surface, characterized in that one or more artificial defects (14) are fabricated in the surface of the first film (13), and thereafter a second film (15) of semiconductor material is deposited on the artificial defect or defects so that its crystallographic orientation is influenced by the defect or defects (14), and a second level of semiconductor devices (16) are fabricated, above the first level (12), in the second film (15).

2.     A method according to claim 1, further including conductively interconnecting elements in the first and second levels.

3.     A method according to claim 1 or claim 2, further including the steps of depositing a third film of material on the surface of the second film, fabricating a second set of one or more artificial defects in the surface of the third film, depositing a fourth film of semiconductor material on the second set of defects so that its crystallographic orientation is influenced by the second set and fabricating a further level of semiconductor devices, above the second level, in the fourth film.

4. A method according to claim 3, further including the step of conductively interconnecting elements in the first, second and further levels.

5. A method according to any of claims 1 to 4, wherein at least some of the artificial defects comprise point defects.

6. A method according to any of claims 1 to 4, wherein at least some of the artificial defects comrpise surface relief structure.

7. A multiple level semiconductor device made in accordance with the method of any of claims 1 to 6.

3D INTEGRATION BY GRAPHOEPITAXY

# EUROPEAN SEARCH REPORT

**European Patent Office**

Application number

00201355 1762
EP 80 30 1762

## DOCUMENTS CONSIDERED TO BE RELEVANT

| Category | Citation of document with indication, where appropriate, of relevant passages | Relevant to claim |
|---|---|---|
| | <u>NL - A - 73 06948</u> (PHILIPS) | 1,6,7 |
| | * Page 3, line 34 - page 10, line 11; page 14, line 31 - page 35, line 16; figures 1-6 * | |
| | & US - A - 4 000 019 | |
| | -- | |
| | <u>FR - A - 2 072 083</u> (IBM) | 1,6 |
| | * Page 4, line 3 - page 10, line 2; figures 1-3 * | |
| | & GB - A - 1 332 464 | |
| | -- | |
| | <u>CH - A - 474 864</u> (SIEMENS) | 1-4,6, 7 |
| | * Column 1, line 24 - column 4, line 4; figure * | |
| | & US - A - 3 564 358 | |
| | -- | |
| | <u>FR - A - 1 454 464</u> (TEXAS INSTRU-MENTS) | 3,4,7 |
| | * Page 1, column 2, paragraph 3 - page 2, column 2, paragraph 4; page 3, column 1, paragraph 9 - page 8, column 1, paragraph 2; figures 2-7 * | |
| | & US - A - 3 748 548 | |
| | & US - A - 3 613 226 | |
| | -- | |
| | <u>US - A - 3 570 114</u> (TEXAS INSTRU-MENTS) | 3,4,7 |
| | * Abstract; column 3, line 1 - column 6, line 53; figures 1-6 * | |
| | -- | |
| | ./.. | |

### CLASSIFICATION OF THE APPLICATION (Int. Cl. 3)

H 01 L 21/20
29/04
27/06

### TECHNICAL FIELDS SEARCHED (Int.Cl. 3)

H 01 L 21/20
29/04
27/06

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 02.09.1980 | CHOMENTOWSKI |

EPO Form 1503.1 06.78

European Patent
Office

EUROPEAN SEARCH REPORT

0020135

Application number

EP 80 30 1762

-2-

## DOCUMENTS CONSIDERED TO BE RELEVANT

| Category | Citation of document with indication, where appropriate, of relevant passages | Relevant to claim |
|---|---|---|
| | JOURNAL OF THE ELECTROCHEMICAL SO-CIETY, vol. 117, nr. 11, November 1970<br>NEW YORK (US)<br>C.M. DRUM et al.: "Anisotropy of Macrostep motion and pattern edge-displacements during growth of epitaxial silicon on silicon near {100}", pages 1401-1405<br><br>* Page 1401, abstract; page 1402, column 1, paragraph 1 - page 1405, column 1, paragraph 2; figures 1-9 * | 1,6 |
| | IBM TECHNICAL DISCLOSURE BULLETIN, vol. 16, nr. 9, February 1974<br>NEW YORK (US)<br>B.K. BISCHOFF et al.: "Selective growth of GaAs", page 3072<br><br>* Page 3072 * | 1,5,6 |
| | JOURNAL OF THE ELECTROCHEMICAL SO-CIETY, vol. 115, June 1968<br>NEW YORK (US)<br>C.M. DRUM et al.: "Geometrical stability of shallow surface depressions during growth of (111) and (100) epitaxial silicon", pages 664-669<br><br>* Page 664, abstract; page 665, column 2, paragraph 4; page 668, column 2, paragraph 6, figures 1-7 * | 1,5,6 |

| CLASSIFICATION OF THE APPLICATION (Int. Cl. 3) |
|---|
| |

| TECHNICAL FIELDS SEARCHED (Int. Cl. 3) |
|---|
| |